# EUROPEAN PATENT SPECIFICATION

(11) **EP 2 037 001 B1**
(45) Date of publication and mention of the grant of the patent: **14.09.2011**
(21) Application number: 07744842.1
(22) Date of filing: 07.06.2007
(51) Int. Cl.: C23C 14/56, C23C 14/24

(54) **TAKE UP TYPE VACUUM VAPOR DEPOSITION DEVICE**
VAKUUMDAMPFABSCHEIDUNGSVORRICHTUNG VOM AUFNAHMETYP
DISPOSITIF DE DÉPOSITION EN PHASE VAPEUR SOUS VIDE DE TYPE À ENROULEMENT

(30) Priority: 23.06.2006 JP 2006173435
(43) Date of publication of application: 18.03.2009
(73) Proprietor: ULVAC, INC., Chigasaki-shi, Kanagawa 253-8543 (JP)
(72) Inventor: HAYASHI, Nobuhiro, Chigasaki-shi, Kanagawa 253-8543 (JP); HIRONO, Takayoshi, Chigasaki-shi, Kanagawa 253-8543 (JP); TADA, Isao, Chigasaki-shi, Kanagawa 253-8543 (JP); NAKATSUKA, Atsushi, Chigasaki-shi, Kanagawa 253-8543 (JP); KOMATSU, Kenji, Chigasaki-shi, Kanagawa 253-8543 (JP)
(74) Representative: Albutt, Anthony John
(86) International application number: PCT/JP2007/061509
(87) International publication number: WO 2007/148539

(56) References cited:
- JP-A- 01 219 097
- JP-A- 58 064 381
- JP-A- 62 052 837
- JP-A- 2005 146 401

## Description

### Technical Field

The present invention relates to a take-up type vacuum vapor deposition apparatus for depositing, while successively paying out an insulation film in a reduced-pressure atmosphere and cooling the film by bringing the film into close contact with a cooling roller, an evaporation material onto the film and taking up the film.

### Background Art

In the related art, take-up type vacuum vapor deposition apparatus, each of which deposits an evaporation material from an evaporation source onto a long film successively paid out from a payout roller and takes up the film that has been subjected to the vapor deposition by a take-up roller, are widely used (see, for example, Patent Document 1 below). In the vacuum vapor deposition apparatus of this type, for preventing thermal deformations of a film during vapor deposition, film formation processing is carried out while the film is cooled by being brought into close contact with a circumferential surface of a cooling can roller. Therefore, how to secure an adhesion operation of the film with respect to the cooling can roller becomes important.

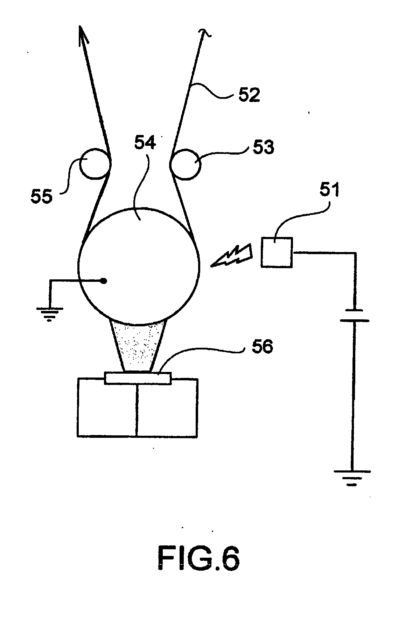

Fig. 6 shows an exemplary structure of the take-up type vacuum vapor deposition apparatus of the related art. A film 52 paid out from a payout roller (not shown) is taken up by a take-up roller (not shown) via a guide roller 53, a cooling can roller 54, and a guide roller 55. An evaporation material from an evaporation source 56 is deposited onto the film 52 on the can roller 54. An electron beam irradiator 51 is disposed between the payout roller and the evaporation source 56, and the film not yet subjected to the vapor deposition is negatively charged when irradiated with electron beams, whereby the film 52 is brought into close contact with the can roller 54 by an electrostatic force generated between the film 52 and the can roller 54 that is grounded. Accordingly, thermal deformations of the film 52 due to insufficient cooling can be prevented.

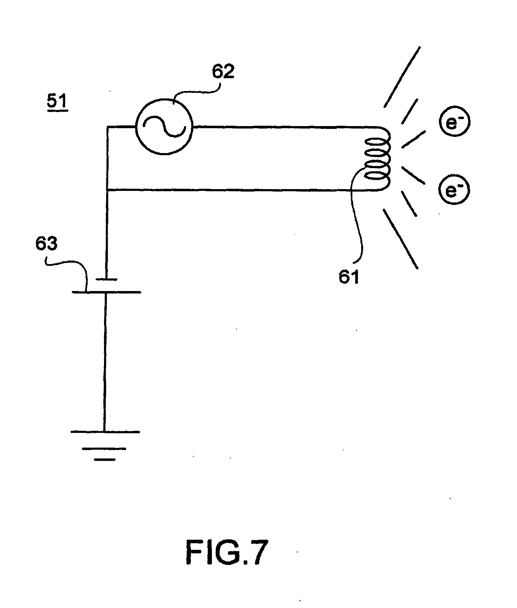

Fig. 7 is an equivalent circuit diagram showing a structure of the electron beam irradiator 51. The electron beam irradiator 51 includes a filament 61 for discharging thermal electrons, a heating power source 62 for energizing the filament 61, and an extraction power source 63 for the electron beams. The heating power source 62 is an AC power source and is constituted of, for example, a commercial frequency supply.

Patent Document 1: Japanese Patent Application Laid-open No. 2005-146401

### Disclosure of the Invention

### Problems to be solved by the Invention

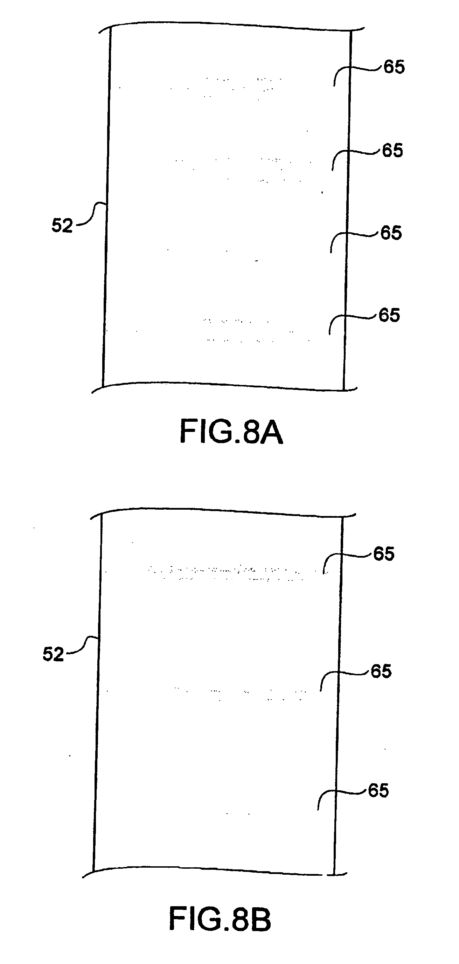

However, the take-up type vacuum vapor deposition apparatus of the related art described above has had a problem in that thermally-affected areas 65 are generated periodically in a longitudinal direction of the film 52 as schematically shown in Fig. 8A. The thermally-affected area 65 is an area of the film that is easily wrinkled or deformed by heat. When a traveling speed of the film 52 is increased, intervals with which the thermally-affected areas 65 are generated become longer as shown in Fig. 8B. In contrast, when the traveling speed of the film 52 is decreased immoderately, the thermally-affected area 65 is not generated at all. However, a decrease in traveling speed of the film is unfavorable because productivity is lowered.

The generation of the thermally-affected areas 65 is caused by insufficient irradiation of electron beams to the film 52. A low irradiation amount of the electron beams leads to weakening of an adhesion force of the film 52 to the can roller 54, resulting in a reduction of a cooling effect. The traveling speed of the film 52 is constant, and the thermally-affected areas are generated periodically. Therefore, it is considered that the thermally-affected areas 65 are generated because of variances in irradiation amount of the electron beams with respect to the film 52.

The present invention has been made in view of the above-mentioned problems, and it is therefore an object of the invention to provide a take-up type vacuum vapor deposition apparatus capable of suppressing generation of thermally-affected areas on a film without lowering productivity.

### Means for solving the Problems

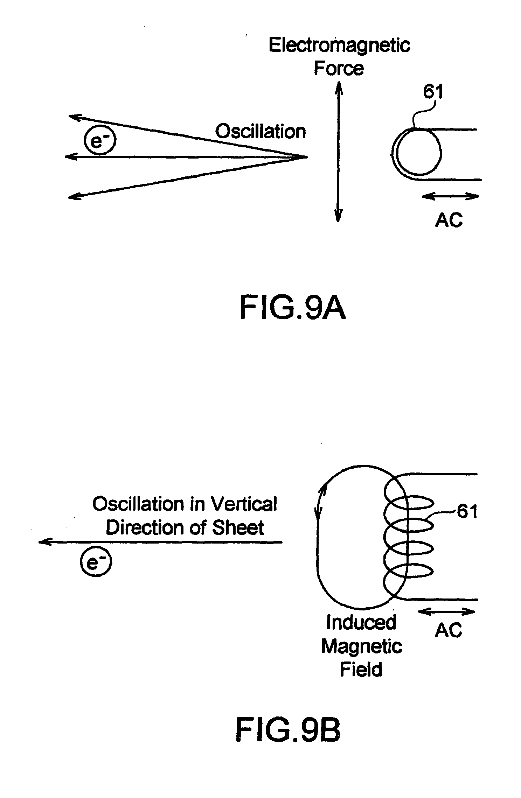

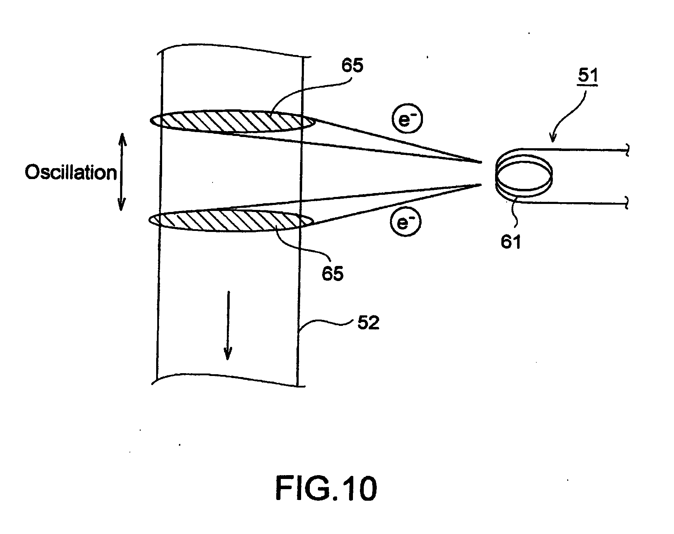

To solve the above-mentioned problems, the inventors of the present invention have conducted keen studies and found that generation of thermally-affected areas on a film is caused by an electrical heating mechanism of a filament constituting an electron beam irradiator as described below. Specifically, as shown in Figs. 9A and 9B, the electron beam irradiator of the related art has generated electron beams by applying an alternating current to the filament 61. At this time, an induced alternating magnetic field corresponding to an alternating current frequency appears around the filament 61, and the generated electron beams receive an electromagnetic force caused by the induced alternating magnetic field, thus oscillating in a direction perpendicular to the induced magnetic field. As a result, as shown in Fig. 10, areas to which an insufficient amount of electron beams are irradiated appear periodically on the film 52 in a traveling direction thereof, the areas being generated on the film 52 as the thermally-affected areas 65.

Thus, according to the present invention, there is provided a take-up type vacuum vapor deposition apparatus, characterized by including: a vacuum chamber; a payout roller disposed inside the vacuum chamber and configured to successively pay out a film having an insulation property; a take-up roller configured to take up the film paid out from the payout roller; a cooling roller disposed between the payout roller and the take-up roller and configured to cool the film by coming into close contact with the film; an evaporation source that faces the cooling roller and configured to deposit an evaporation material on the film; and an electron beam irradiator disposed between the payout roller and the evaporation source and configured to irradiate the film with an electron beam while the film is traveling, and in that the electron beam irradiator includes a filament configured to discharge electrons by electrical heating and DC generation means for supplying a direct current to the filament.

In the present invention, by electrically heating the filament constituting the electron beam irradiator using a direct current, the oscillation of the electron beams caused by the induced alternating magnetic field generated around the filament is eliminated in principle, thus obtaining a uniform irradiation operation of the electron beams with respect to the film. Accordingly, it becomes possible to obtain an adhesion operation between an entire surface of the film and the cooling roller, and prevent generation of thermally-affected areas due to a decrease in cooling effect, without lowering productivity.

An example of a specific structure of the DC generation means is a structure in which the heating power source of the filament is constituted of a DC power source. Further, a direct current can be supplied to the filament by constituting the heating power source by an AC power source and inserting a DC conversion circuit including a rectification device to the AC power source.

### Effect of the Invention

As described above, according to the take-up type vacuum vapor deposition apparatus of the present invention, it becomes possible to obtain an adhesion operation between an entire surface of the film and the cooling roller, and prevent generation of thermally-affected areas due to a decrease in cooling effect, without lowering productivity.

### Brief Description of Drawings

[Fig. 1] Fig. 1 is a schematic structural diagram of a take-up type vacuum vapor deposition apparatus according to an embodiment of the present invention.
[Fig. 2] Fig. 2 is a schematic cross-sectional diagram for illustrating a process of irradiating electron beams to a film.
[Fig. 3] Fig. 3 is an equivalent circuit diagram for illustrating a structure of an electron beam irradiator used in the take-up type vacuum vapor deposition apparatus shown in Fig. 1.
[Fig. 4] Fig. 4 is a schematic diagram for illustrating an operation of the electron beam irradiator shown in Fig. 3.
[Figs. 5] Figs. 5 are diagrams each showing a structural modification of the electron beam irradiator shown in Fig. 3.
[Fig. 6] Fig. 6 is a schematic structural diagram showing main portions of a take-up type vacuum vapor deposition apparatus of the related art.
[Fig. 7] Fig. 7 is an equivalent circuit diagram for illustrating a structure of an electron beam irradiator used in the take-up type vacuum vapor deposition apparatus of the related art.
[Figs. 8] Figs. 8 are diagrams for illustrating problems of the related art, each of which shows an example where thermally-affected areas are generated periodically on a film.
[Figs. 9] Figs. 9 are schematic diagrams each illustrating a state where an electron beam is oscillated when an alternating current is applied to a filament constituting the electron beam irradiator.
[Fig. 10] Fig. 10 is a schematic diagram for illustrating a mechanism for generating thermally-affected areas shown in Figs. 8.

### Description of Reference Numerals

- 10: take-up type vacuum vapor deposition apparatus
- 11: vacuum chamber
- 12: film
- 13: payout roller
- 14: can roller (cooling roller)
- 15: take-up roller
- 16: evaporation source
- 18: auxiliary roller
- 21: electron beam irradiator
- 22: DC bias power source
- 23: neutralization unit
- 31: filament
- 32: DC power source
- 33: extraction power source
- 36: rectification device
- 37, 39: capacitor
- 38: diode bridge

### Best Mode for Carrying Out the Invention

Hereinafter, an embodiment of the present invention will be described with reference to the drawings.

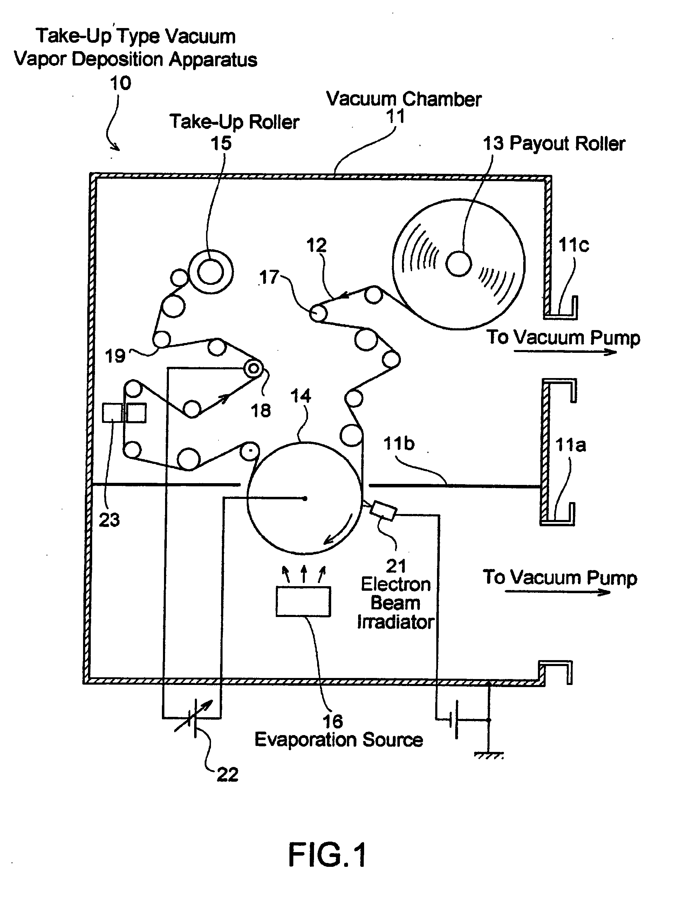

Fig. 1 is a schematic structural diagram of a take-up type vacuum vapor deposition apparatus 10 according to the embodiment of the present invention. The take-up type vacuum vapor deposition apparatus 10 of this embodiment includes a vacuum chamber 11, a payout roller 13 for a film 12, a cooling can roller 14, a take-up roller 15, and an evaporation source 16 of an evaporation material.

The vacuum chamber 11 is connected to a vacuum exhaust system such as a vacuum pump (not shown) via pipe connection portions 11a and 11c, and is exhausted to reduce a pressure inside to a predetermined vacuum degree. An internal space of the vacuum chamber 11 is sectioned by a partition plate 11b into a room in which the payout roller 13, the take-up roller 15, and the like are disposed, and a room in which the evaporation source 16 is disposed.

The film 12 is constituted of a long plastic film having an insulation property and cut at a predetermined width. In this embodiment, an OPP (drawn polypropylene) single-layer film is used for the film 12. It should be noted that a plastic film such as a PET (polyethylene terephthalate) film and a PPS (polyphenylene sulfide) film, a paper sheet, and the like can be applied instead.

The film 12 is successively paid out from the payout roller 13 and is taken up by the take-up roller 15 via a plurality of guide rollers 17, the can roller 14, an auxiliary roller 18, and a plurality of guide rollers 19. Although not shown, each of the payout roller 13 and the take-up roller 15 is provided with a rotary drive portion.

The can roller 14 is tubular and made of metal such as iron. Inside, the can roller 14 has a cooling mechanism such as a cooling medium circulation system, a rotary drive mechanism for rotationally driving the can roller 14, and the like. The film 12 is wound around a circumferential surface of the can roller 14 at a predetermined holding angle. The film 12 wound around the can roller 14 is deposited with, on a deposition surface on an outer surface side thereof, an evaporation material from the evaporation source 16 so as to form a deposited layer, and at the same time, is cooled by the can roller 14.

The evaporation source 16 accommodates the evaporation material and has a mechanism for causing the evaporation material to evaporate by heating using a well-known technique such as resistance heating, induction heating, and electron beam heating. The evaporation source 16 is disposed below the can roller 14, and causes the vapor of the evaporation material to adhere onto the film 12 on the can roller 14 opposed to the evaporation source 16, to thus form a deposited layer.

As the evaporation material, in addition to a metal element single body such as Al, Co, Cu, Ni, and Ti, two or more metals such as Al-Zn, Cu-Zn, and Fe-Co, or a multi-component alloy can be used. In addition, the number of evaporation source is not limited to one, and a plurality of evaporation sources may be provided.

The take-up type vacuum vapor deposition apparatus 10 of this embodiment additionally includes an electron beam irradiator 21, a DC bias power source 22, and a neutralization unit 23.

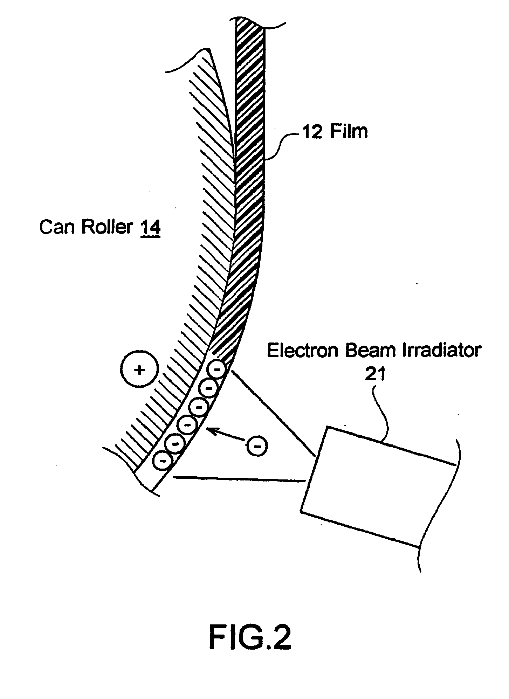

The electron beam irradiator 21, which is disposed between the payout roller 13 and the evaporation source 16, negatively charges the film 12 by irradiating electron beams onto the traveling film 12. Fig. 2 is a schematic cross-sectional diagram for illustrating a process of irradiating electron beams to the film 12. The electron beam irradiator 21 is disposed so as to oppose the circumferential surface of the can roller 14, and irradiates electron beams onto a deposition surface of the film 12 that is in contact with the can roller 14 at an irradiation width the same as or higher than a film width.

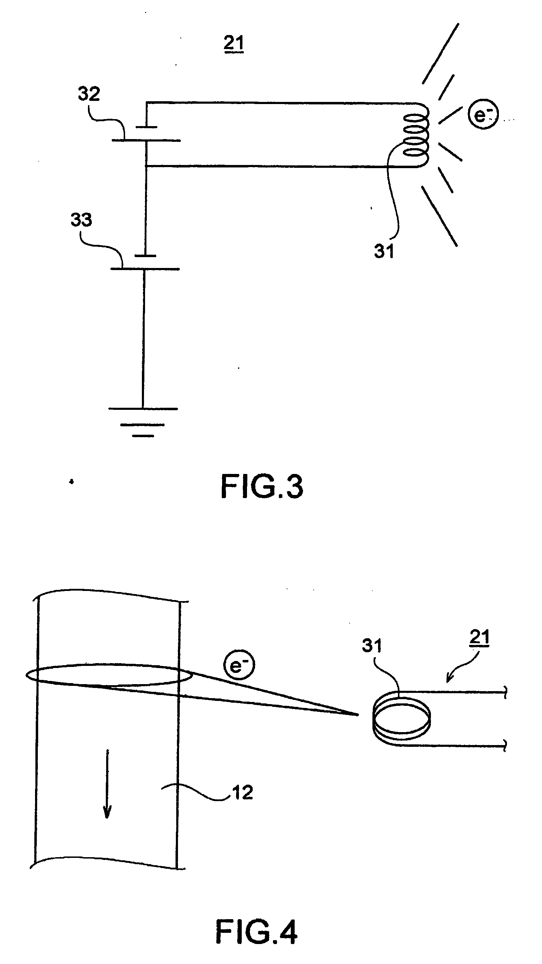

Fig. 3 is an equivalent circuit diagram showing a structure of the electron beam irradiator 21. The electron beam irradiator 21 includes a filament 31 for discharging thermal electrons, a heating power source 32 for energizing the filament 31, and an extraction power source 33 for the electron beams. The heating power source 32 is constituted of a DC power source, thus constituting "DC generation means" of the present invention for supplying a direct current to the filament 31.

The DC bias power source 22 applies a predetermined DC voltage between the can roller 14 and the auxiliary roller 18. The can roller 14 is connected to a positive electrode whereas the auxiliary roller 18 is connected to a negative electrode. The auxiliary roller 18 is made of metal and disposed at a position where the deposition surface of the film 12 comes into rotational contact with a circumferential surface thereof. When a metallic layer formed on the film 12 comes into contact with the auxiliary roller 18, the film 12 sandwiched between the metallic layer and the can roller 14 is polarized, and electrostatic absorption power is generated between the film 12 and the can roller 14. Accordingly, the film 12 and the can roller 14 are brought into close contact with each other.

The neutralization unit 23 is disposed between the cooling can roller 14 and the take-up roller 15 and has a function of neutralizing the film 12 that has been charged by being irradiated with electron beams from the electron beam irradiator 21. As an exemplary structure of the neutralization unit 23 in this embodiment, a mechanism for neutralizing the film 12 by carrying out bombard processing while causing the film 12 to pass through plasma is used.

Next, descriptions will be given on an operation of the take-up type vacuum vapor deposition apparatus 10 of this embodiment structured as described above.

Inside the vacuum chamber 11 that is pressure-reduced to a predetermined vacuum degree, the film 12 successively paid out from the payout roller 13 is subjected to an electron beam irradiation process, a vapor deposition process, and a neutralization process before being successively taken up by the take-up roller 15.

The film 12 paid out from the payout roller 13 is wound around the can roller 14. The film 12 is irradiated with, in the vicinity of a position at which the film 12 starts to come into contact with the can roller 14, the electron beams from the electron beam irradiator 21 to be negatively charged in potential. At this time, because the film 12 is irradiated with the electron beams at a position in contact with the can roller 14, it is possible to effectively cool the film 12 while bringing the film 12 in close contact with the can roller 14.

Here, according to this embodiment, because the filament 31 constituting the electron beam irradiator 21 is electrically heated using a direct current, it is possible to eliminate, in principle, the oscillation of the electron beams due to an induced alternating magnetic field generated around the filament, which has been a problem in the system of the related art in which the filament is energized by an alternating current, and obtain a uniform irradiation operation of the electron beams with respect to the film 12 as schematically shown in Fig. 4. Thus, it becomes possible to obtain an adhesion operation between an entire surface of the film and the can roller 14, and prevent generation of thermally-affected areas due to a decrease in cooling effect without lowering productivity.

The film 12 negatively charged by being irradiated with the electron beams is brought into close contact with, through electrostatic attractive force, the can roller 14 that is biased to a positive electric potential by the DC bias power source 22. Then, the evaporation material evaporated from the evaporation source 16 is deposited onto the deposition surface of the film 12 to thus form a metallic layer.

The metallic layer formed on the film 12 is applied with a negative electric potential by the DC bias power source 22 via the auxiliary roller 18. The metallic layer is formed successively in a longitudinal direction of the film 12. Thus, the film 12 wound around the can roller 14 and deposited with the metallic layer is positively polarized on a surface on the metallic layer side and negatively polarized on the other surface on the can roller 14 side, and electrostatic absorption power is generated between the film 12 and the can roller 14. As a result, the film 12 and the can roller 14 are brought into close contact with each other.

As described above, in this embodiment, before the vapor deposition of the metallic layer, the film 12 is brought into close contact with the can roller 14 by being charged by irradiation of the electron beams, whereas after the vapor deposition of the metallic layer, the film 12 is brought into close contact with the can roller 14 by a bias voltage applied between the metallic layer and the can roller 14. Thus, even if partial charge (electrons) charged with respect to the film 12 before the vapor deposition of the metallic layer is discharged to the metallic layer and lost in the vapor deposition process of the metallic layer thereafter, a part or all of the lost charge can be compensated for by applying a negative electric potential (supplying electrons) to the metallic layer from the auxiliary roller 18.

Therefore, according to this embodiment, lowering of the adhesion force between the film 12 and the can roller 14 is suppressed even after the vapor deposition process, and a stable cooling operation of the film 12 can be secured before and after the vapor deposition process. Accordingly, thermal deformations of the film 12 during the vapor deposition of the metallic layer can be prevented, and an increase in traveling speed of the film 12 and deposition operation speed is enabled to thus improve productivity.

The film 12 onto which the metallic layer is deposited as described above is neutralized by the neutralization unit 23, and is then taken up by the take-up roller 15. Thus, it becomes possible to prevent wrinkles caused during winding due to the charge while securing a stable take up operation of the film 12.

Although the embodiment of the present invention has been described above, the present invention is of course not limited thereto, and can be variously modified based on the technical idea of the present invention.

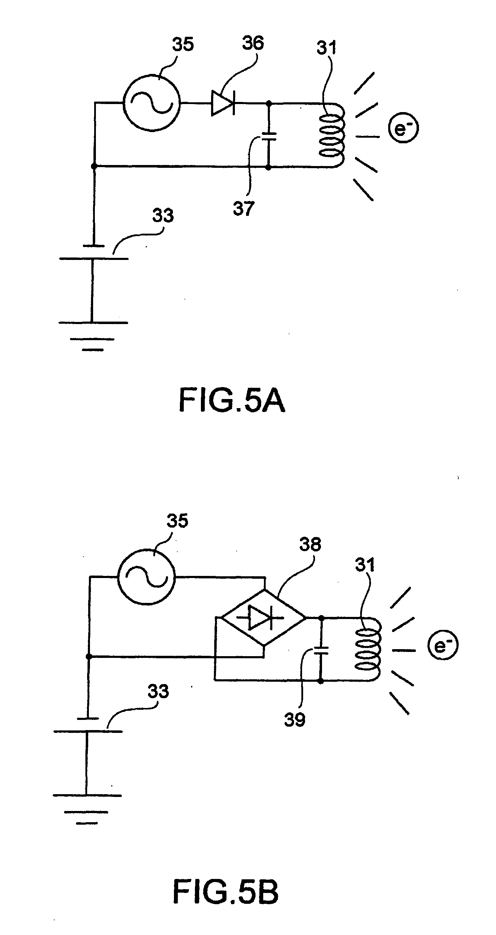

For example, in the above embodiment, the heating power source 32 constituted of a DC power source is used as the DC generation means for supplying a direct current to the filament 31 constituting the electron beam irradiator 21. However, as shown in Figs. 5A and 5B, for example, the DC generation means may instead be constituted by an AC power source 35 and a DC conversion circuit including a rectification device.

Fig. 5A shows an equivalent circuit of an electron beam irradiator in which a DC conversion circuit constituted of a rectification device 36 and a capacitor 37 is inserted between the filament 31 for discharging thermal electrons and the AC power source 35. The rectification device 36 converts an alternating current from the AC power source 35 into a direct current (half-wave rectification), and the capacitor 37 functions as a filter for smoothening the rectified waveform.

Further, Fig. 5B shows an equivalent circuit of an electron beam irradiator in which a DC conversion circuit constituted of a diode bridge 38 and a capacitor 39 is inserted between the filament 31 for discharging thermal electrons and the AC power source 35. The diode bridge 38 converts the alternating current from the AC power source 35 into a direct current (full-wave rectification), and the capacitor 39 functions as a filter for smoothening the rectified waveform.

## Claims

1. A take-up type vacuum vapor deposition apparatus (10), comprising:
a vacuum chamber (11);
a payout roller (13) disposed inside the vacuum chamber (11) and configured to successively pay out a film (12) having an insulation property;
a take-up roller (15) configured to take up the film (12) paid out from the payout roller (13);
a cooling roller (14) disposed between the payout roller (13) and the take-up roller (15) and configured to cool the film (12) by coming into close contact with the film (12);
an evaporation source (16) that faces the cooling roller (14) and configured to deposit an evaporation material on the film (12); and
an electron beam irradiator (21) disposed between the payout roller (13) and the evaporation source (16) and configured to irradiate the film (12) with an electron beam while the film (12) is traveling,
**characterized in that** the electron beam irradiator (21) includes a filament (31) configured to discharge electrons by electrical heating and a direct current source (32, (3 5, 3 6), (35, 38)) for supplying a direct current to the filament (31) for heating.

2. The take-up type vacuum vapor deposition apparatus according to claim 1, wherein the direct current source is a DC power source.

3. The take-up type vacuum vapor deposition apparatus according to claim 1, wherein the direct current source is constituted of an AC power source (35) and a DC conversion circuit including a rectification device (36, 38).

## Patentansprüche

1. Vakuumdampfabscheidevorrichtung (10) vom Aufnahmetyp mit:
einer Vakuumkammer (11),
einer Ausgaberolle (13), die innerhalb der Vakuumkammer (11) angeordnet ist und die so eingerichtet ist, dass sie sukzessive einen Film (12) mit einer isolierenden Eigenschaft ausgibt,
einer Aufnahmerolle (15), die so eingerichtet ist, dass sie den von der Ausgaberolle (13) ausgegebenen Film (12) aufnimmt,
einer Kühlrolle (14), die zwischen der Ausgaberolle (13) und der Aufnahmerolle (15) angeordnet ist und die so eingerichtet ist, dass sie den Film (12) durch enges in Kontakt kommen mit dem Film (12) kühlt,
einer Verdampfungsquelle (16), die zu der Kühlrolle (14) hinzeigt und die so eingerichtet ist, dass sie ein Verdampfungsmaterial auf dem Film (12) abscheidet, und
einem Elektronenstrahlbestrahler (21), der zwischen der Ausgaberolle (13) und der Verdampfungsquelle (16) angeordnet ist und der so eingerichtet ist, dass er den Film (12) mit einem Elektronenstrahl bestrahlt während sich der Film (12) bewegt,
**dadurch gekennzeichnet, dass** der Elektronenstrahlbestrahler (21) ein Filament (31), das so eingerichtet ist, dass es Elektronen durch elektrisches Heizen entlädt, und eine Gleichstromquelle (32, (35, 36), (35, 38)) zum Bereitstellen eines Gleichstroms an das Filament (31) zum Heizen aufweist.

2. Vakuumdampfabscheidevorrichtung vom Aufnahmetyp nach Anspruch 1, wobei die Gleichstromquelle eine Gleichspannungsquelle ist.

3. Vakuumdampfabscheidevorrichtung vom Aufnahmetyp nach Anspruch 1, wobei die Gleichstromquelle aus einer Wechselspannungsquelle (35) und einem Gleichspannungswandlerschaltkreis mit einer Gleichrichtereinrichtung (36, 38) gebildet ist.

## Revendications

1. Appareil de dépôt en phase vapeur sous vide de type à enroulement (10), comprenant :
une chambre sous vide (11) ;
un rouleau de déroulement (13) disposé à l'intérieur de la chambre sous vide (11) et configuré pour dérouler successivement un film (12) ayant une propriété d'isolation ;
un rouleau à enroulement (15) configuré pour enrouler le film (12) déroulé du rouleau de déroulement (13) ;
un rouleau de refroidissement (14) disposé entre le rouleau de déroulement (13) et le rouleau à enroulement (15) et configuré pour refroidir le film (12) en entrant en contact étroit avec le film (12) ;
une source d'évaporation (16) disposée face au rouleau de refroidissement (14) et configurée pour déposer une matière d'évaporation sur le film (12) ; et
un dispositif d'irradiation (21) par faisceau électronique disposé entre le rouleau de déroulement (13) et la source d'évaporation (16) et configuré pour irradier le film (12) par un faisceau électronique pendant que le film (12) est en déplacement,
**caractérisé en ce que** le dispositif d'irradiation (21) par faisceau électronique comprend un filament (31) configuré pour émettre des électrons par chauffage électrique et une source de courant continu (32, (35, 36), (35, 38)) pour adresser un courant continu au filament (31) afin de le chauffer.

2. Appareil de dépôt en phase vapeur sous vide de type à enroulement selon la revendication 1, dans lequel la source de courant continu est une source de puissance en courant continu.

3. Appareil de dépôt en phase vapeur sous vide de type à enroulement selon la revendication 1, dans lequel la source de courant continu est constituée d'une source de puissance en courant alternatif (35) et d'un circuit de conversion en courant continu comprenant un dispositif de redressement (36, 38).
